Europäisches Patentamt

European Patent Office

Office européen des brevets

(11) Veröffentlichungsnummer: **0 360 050**
**A1**

(12) **EUROPÄISCHE PATENTANMELDUNG**

(21) Anmeldenummer: **89116096.2**

(51) Int. Cl.5: **H01L 21/332 , H01L 21/225**

(22) Anmeldetag: **31.08.89**

(30) Priorität: **13.09.88 CH 3414/88**

(43) Veröffentlichungstag der Anmeldung:
**28.03.90 Patentblatt 90/13**

(84) Benannte Vertragsstaaten:
**AT BE CH DE FR GB IT LI NL**

(71) Anmelder: **ASEA BROWN BOVERI AG**
**Haselstrasse**
**CH-5401 Baden(CH)**

(72) Erfinder: **Roggwiller, Peter, Dr.**
**Püntstrasse 16**
**CH-8173 Riedt-Neerach(CH)**
Erfinder: **Vlasak, Thomas**
**Adelmatt 336**
**CH-5242 Birr(CH)**

(54) **Verfahren zur Herstellung eines GTO-Thyristors.**

(57) Bei einem Verfahren zur Herstellung von GTOs
wird die Segmentierung in die einzelnen Teilthyristoren in der Weise durchgeführt, dass nach dem Belegen der kathodenseitigen Substratoberfläche mit einem Donator, aber vor der Eindiffusion der n-Emitterbereiche (13) die Gräben (16a,b) in das Substrat (1) hineingeätzt werden.

Durch dieses Vorgehen wird ein zusätzlicher Dickenverlust bei der p-Basisschicht (10) vermieden, sodass ein GTO mit verbesserten elektrischen Eigenschaften entsteht.

FIG.2B

FIG.2C

EP 0 360 050 A1

## Verfahren zur Herstellung eines GTO-Thyristors

Technisches Gebiet

Die vorliegende Erfindung bezieht sich auf das Gebiet der Leistungselektronik. Sie betrifft insbesondere ein Verfahren zur Herstellung eines GTO-Thyristors, bei welchem Verfahren in ein mit einer Schichtenfolge aus einer n-Basisschicht und einer p-Basisschicht versehenen Substrat eine Vielzahl von durch Gräben getrennten n-Emitterbereichen eingebracht werden.

Ein solches Verfahren ist z.B. aus der Patentschrift US-A-4,243,999 bekannt.

Stand der Technik

Gate-abschaltbare Thyristoren (GTOs) herkömmlicher Bauart bestehen aus einer grossen Anzahl (bis zu 2000) von in einem Substrat monolithisch integrierten Einzelthyristoren, die über einen gemeinsamen Gatekontakt ein- und ausgeschaltet werden können.

Bei der Herstellung solcher GTOs wird von einem Substrat mit einer ganzflächigen PN-Schichtstruktur aus n-Basisschicht und p-Basisschicht ausgegangen, welche die geforderte Sperrspannung aufnehmen kann. Ueber dieser PN-Schichtstruktur wird beim bekannten Verfahren eine ganzflächige n-Emitterschicht in das Substrat eingebracht. Anschliessend erfolgt die Unterteilung in die einzelnen Teilthyristoren durch Ausheben von trennenden Gräben, d.h. durch lokales Ausätzen der n-Emitterschicht. Diese Segmentierung erfolgt üblicherweise nach der Durchführung sämtlicher Heissprozesse zum Eindiffundieren der verschiedenen Dotierstoffe.

Um dabei eine sichere Trennung zwischen dem Gate (der p-Basisschicht) und der Kathode (der n-Emmiterschicht) zu gewährleisten, muss in der Praxis die Aetztiefe 10-20% über der Eindringtiefe des PN-Uebergangs zwischen n-Emitterschicht und p-Basisschicht liegen. Dadurch muss unter Umständen unnötig viel vom hochdotierten Teil der p-Basisschicht entfernt werden.

Darüberhinaus ist nach der Segmentierungs-Aetzung die Substratoberfläche zwischen Gate- und Kathodenelektrode ungeschützt und muss durch eine zusätzliche Beschichtung passiviert werden, weil der Zustand dieses Teils der Oberfläche (insbesondere die hier vorhandene Dichte an Ladungsträger-Traps) die elektrischen Eigenschaften des Bauelements wie z.B. das Zündverhalten massiv beeinflussen kann.

Darstellung der Erfindung

Aufgabe der vorliegenden Erfindung ist es daher, für die Herstellung von GTOs ein Verfahren anzugeben, welches ohne unnötige Verluste bei der p-Emitterschicht die sichere elektrische Trennung zwischen Gate und Kathode gewährleistet und eine vereinfachte Passivierung der kritischen Oberflächenbereiche gestattet.

Die Aufgabe wird bei einem Verfahren der eingangs genannten Art dadurch gelöst, dass

(a) in die p-Basisschicht zunächst eine oberflächennahe, ganzflächige und einen Donator enthaltende Prädepositionsschicht eingebracht wird;

(b) danach die Gräben ausgehoben werden, welche die Prädepositionsschicht in eine Vielzahl von getrennten Prädepositionsbereichen unterteilen; und

(c) anschliessend der Donator aus den Prädepositionsbereichen in das Substrat eindiffundiert wird, um die n-Emitterbereiche zu bilden.

Der Kern der Erfindung besteht also darin, die Segmentierung bereits vor dem endgültigen Eindiffundieren der n-Emitterschicht vorzunehmen, solange sich der Donator noch in einer oberflächennahen Prädepositionsschicht befindet. Die Tiefe der Grabenätzung braucht auf diese Weise nicht an der Tiefe der n-Emitterschicht ausgerichtet zu werden, sondern die Eindiffusion der n-Emitterschicht richtet sich umgekehrt nach der vorgegebenen Grabentiefe.

Dieses Vorgehen hat folgende Vorteile:
-- die Aetztiefe kann praktisch frei gewählt werden und richtet sich im wesentlichen nur noch nach dem minimal erforderlichen vertikalen Abstand zwischen Gate- und Kathodenelektrode, wobei die elektrische Trennung zwischen Gate-und n-Emitterbereich in der Praxis immer gewährleistet ist;
-- während der nachfolgenden Eindiffusion der n-Emitterschicht kann gleichzeitig die gesamte strukturierte Substratoberfläche mit einer Abdeckschicht versehen werden (bei einem Si-Substrat mit einer $SiO_2$-Schicht). Diese Abdeckschicht stellt eine Passivierung des empfindlichen Oberflächenbereichs zwischen Gate und Kathode dar und bewirkt ausserdem eine Reduktion der Oberflächenrekombination, wodurch das Zündverhalten des GTO günstig beeinflusst wird. Zur Kontaktierung von Gate und Kathode werden anschliessend Fenster in die Abdeckschicht geätzt, wodurch geometrisch sehr genau definierte Kontaktflächen entstehen , was eine verbesserte Homogenität für die Gesamtstruktur bedeutet. Der Schutz durch die Abdeckschicht wirkt sich auch beim Aufbringen und Strukturieren der Elektroden-Metallisierung günstig aus;

-- beim erfindungsgemässen Verfahren findet bei der Eindiffusion der n-Emitterschicht auch eine laterale Diffusion in die Bereiche unterhalb der Gräben statt. Dadurch kann zwischen dem PN-Uebergang von n-Emitterschicht und p-Basisschicht und der Substratoberfläche ein sogenannter positiver Winkel entstehen, wodurch die Durchbruchspannung zwischen Gate und Kathode erhöht wird.

Gemäss einem bevorzugten Ausführungsbeispiel der Erfindung wird beim Eindiffundieren des n-Dotierstoffes aus den Prädepositionsbereichen die durch die Gräben strukturierte Oberfläche des Substrats gleichzeitig mit einer Abdeckschicht versehen.

Weitere Ausführungsbeispiele ergeben sich aus den Unteransprüchen.

Kurze Beschreibung der Zeichnung

Die Erfindung soll nachfolgend anhand von Ausführungsbeispielen im Zusammenhang mit der Zeichnung näher erläutert werden. Es zeigen

Fig.1A-E verschiedene Schritte bei der Herstellung eines GTO nacht dem bekannten Verfahren; und

Fig.2A-E verschiedene Schritte bei der Herstellung eines GTO gemäss einem Ausführungsbeispiel der Erfindung.

Wege zur Ausführung der Erfindung

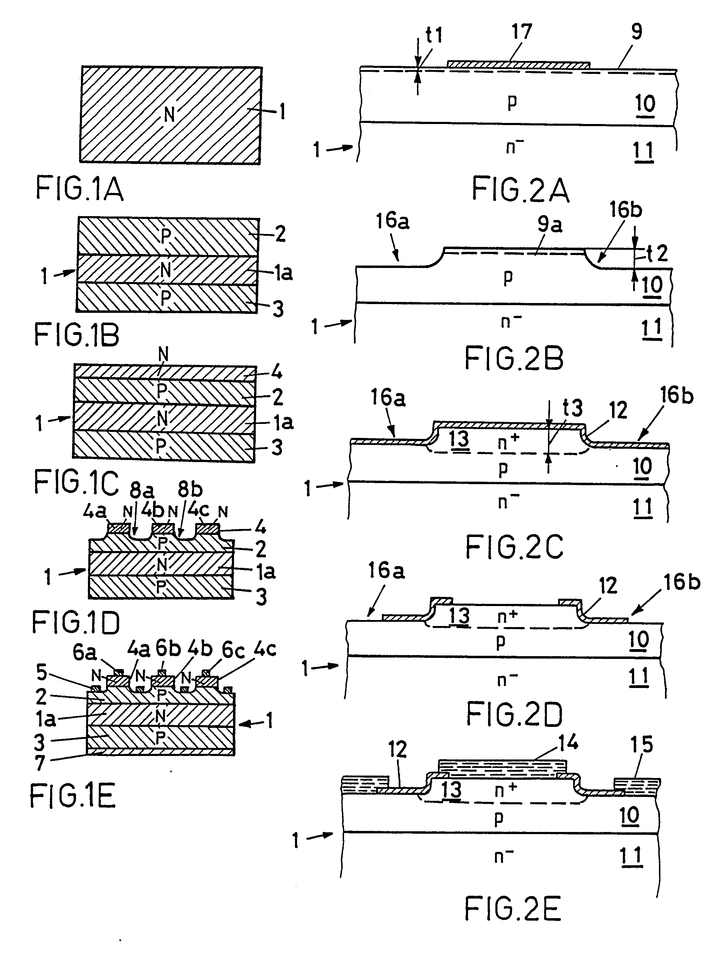

Nach dem Stand der Technik, wie er beispielsweise aus der US-A-4,243,999 zu entnehmen ist, wird bei der Herstellung eines GTO folgendermassen vorgegangen (Fig.1A-E):

Ausgangspunkt des Verfahrens ist ein n-dotiertes Substrat 1 (Fig.1A). Diese Substrat 1 wird einer beidseitigen p-Diffusion unterworfen und erhält auf diese Weise eine Schichtenfolge aus einer p-dotieiten p-Emitterschicht 3, einer mit der Grunddotierung des Substrats 1 versehenen n-Basisschicht 1a und einer p-dotierten p-Basisschicht 2 (Fig.1B).

Auf der Seite der p-Basisschicht 2 wird anschliessend durch Eindiffusion eines Donators eine ganzflächige n-Emitterschicht 4 in das Substrat 1 eingebracht (Fig.1C).

Nachdem auf diese Weise ganzflächig die PNPN-Schichtenfolge in ihrer endgültigen Form festgelegt worden ist, wird durch Ausätzen von Gräben 8a,b eine Segmentierung vogenommen (Fig.1D), bei der die n-Emitterschicht 4 in eine Vielzahl von n-Emitterbereichen 4a,b,c unterteilt wird. Die Tiefe der Gräben 8a,b wird dabei aus Sicherheitsgründen deutlich grösser gewählt als die Tiefe der n-Emitterschicht, d.h. des PN-Uebergangs zwischen nEmitterschicht 4 und p-Basisschicht 2.

Zur Kontaktierung des Bauelements werden schliesslich (Fig. 1E) auf der Unterseite der p-Emitterschicht 3 eine Anodenelektrode 7, auf den n-Emitterbereichen 4a,b,c jeweils Kathodenelektroden 6a,b,c, und auf den Grabenböden Gateelektroden 5 in Form von Metallisierungen aufgebracht.

Während beim herkömmlichen Verfahren die Segmentierung nach der endgültigen Diffusion der n-Emitterschicht vorgenommen wird und somit aus den bereits erwähnten Gründen einen erheblichen Verlust an Schichtdicke der p-Basisschicht mit sich bringt, geht die Erfindung einen anderen Weg (Fig.2A-E).

Auch das erfindungsgemässe Verfahren geht von einem beidseitig p-diffundierten Substrat mit n-Grunddotierung aus, wie es in Fig.1B wiedergegeben ist. In ein solchermassen vorbereitetes Substrat 1, das unter anderem eine n-Basisschicht 11 und eine p-Basisschicht 10 enthält und vorzugsweise aus Si besteht, wird in einem ersten Schritt auf der Seite der p-Basisschicht 10 eine oberflächennahe Prädepositionsschicht 9 mit geringer Tiefe $t1$ eingebracht, die einen Donator (z.B. P) enthält (Fig.2A).

Die Prädepositionsschicht 9 kann beispielsweise durch Ionenimplantation oder mittels einer $POCl_3$-Quelle erzeugt werden. Ihre Tiefe $t1$ ist vorzugsweise kleiner als 2 $\mu m$, insbesondere etwa 1,5 $\mu m$ oder darunter.

Nach dem Einbringen der Prädepositionsschicht 9 wird das Substrat 1 auf dieser Seite mit einer strukturierten Aetzmaske 17 z.B. aus Photoresist oder $SiO_2$) bedeckt (Fig.2A) und anschliessend einem Aetzprozess unterworfen, bei dem Gräben 16a,b in das Substrat 1 hineingeätzt werden, die durch die Prädepositionsschicht 9 hindurch weit in die p-Basisschicht 10 hineinragen (Fig.2B).

Die ganzflächige Prädepositionsschicht 9 wird durch die Gräben 16a,b in eine Vielzahl von getrennten Prädepositionsbereichen 9a unterteilt, die als Dotierstoffquellen bei der nachfolgenden Eindiffusion entsprechender n-Emitterbereiche 13 dienen (Fig.2C). Die Tiefe $t2$ der Gräben 16a,b ist vorzugsweise gleich oder grösser als 10 $\mu m$.

Beim Eindiffundieren der n-Emitterbereiche 13 (Fig.1C) wird gemäss einem bevorzugten Ausführungsbeispiel der Erfindung die durch die Gräben 16a,b strukturierte Oberfläche des Substrats 1 gleichzeitig mit einer Abdeckschicht 12 (bei einem Si-Substrat aus $SiO_2$) ganzflächig bedeckt. Die Abdeckschicht 12 gewährleistet beim späteren Bauelement eine sichere Passivierung des kritischen Oberflächenbereichs an den Seitenwänden der Gräben 16a,b.

Die Tiefe $t3$ der n-Emitterbereiche 13, d.h. der PN-Uebergänge zwischen den n-Emitterbereichen 13 und der p-Basisschicht 10 wird vorzugsweise grösser gewählt als die Tiefe t2 der Gräben 16a,b, sodass aufgrund der lateralen Diffusion die genannten PN-Uebergänge (wie in FIG.2C-E angedeutet) nicht mehr unter einem rechten Winkel an die Substratoberfläche treten, sondern einen in der Fachliteratur als "positiv" bezeichneten Winkel bilden, der zu verbesserten Sperreigenschaften führt. Als besonders günstig haben sich für die Tiefen t2 und t3 Werte von etwa 10 μm bzw. etwa 15 μm herausgestellt.

Die Dotierungskonzentrationen in den einzelnen Schichten und Bereichen können in üblicher Weise gewählt werden. Als Beispiel seien hier für die Randkonzentration der p-Basisschicht 10 ein Wert von $1 \cdot 10^{18}$ $cm^{-3}$ und für die Randkonzentration der n-Emitterbereiche 13 ein Wert von $2 \cdot 10^{19}$ $cm^{-3}$ oder grösser genannt.

Im weiteren Verlauf des Verfahrens werden in der Abdeckschicht 12 über den n-Emitterbereichen 13 und in den Gräben 16a,b durch lokales Aetzen Fenster geöffnet (Fig.2D), die eine spätere Kontaktierung der n-Emitterbereiche 13 bzw. der p-Basisschicht 10 durch Kathodenelektroden 14 bzw. Gateelektroden 15 (z.B. in Form einer Al-Metallisierung) gestatten (Fig.2E).

Da bei dem erfindungsgemässen Verfahren kein tiefliegender PN-Uebergang durchtrennt werden muss, sondern nur die oberflächennahe Prädepositionsschicht 9, kann die Grabenätzung ohne zusätzlichen Verlust bei der p-Basisschicht 10 durchgeführt werden. Darüberhinaus lässt sich die Diffusion aus den Prädepositionsbereichen 9a in einfacher Weise mit einer Passivierung durch die Abdeckschicht 12 verbinden, sodass ein GTO mit insgesamt deutlich verbesserten elektrischen Eigenschaften entsteht.

## Ansprüche

1. Verfahren zur Herstellung eines GTO-Thyristors, bei welchem Verfahren in ein mit einer Schichtenfolge aus einer n-Basisschicht (11) und einer p-Basisschicht (10) versehenen Substrat (1) eine Vielzahl von durch Gräben (16a,b) getrennten n-Emitterbereichen (13) eingebracht werden, dadurch gekennzeichnet, dass

(a) in die p-Basisschicht (10) zunächst eine oberflächennahe, ganzflächige und einen Donator enthaltende Prädepositionsschicht (9) eingebracht wird;

(b) danach die Gräben (16a,b) ausgehoben werden, welche die Prädepositionsschicht (9) in eine Vielzahl von getrennten Prädepositionsbereichen (9a) unterteilen; und

(c) anschliessend der Donator aus den Prädepositionsbereichen (9a) in das Substrat (1) eindiffundiert wird, um die n-Emitterbereiche (13) zu bilden.

2. Verfahren nach Anspruch 1, dadurch gekennzeichnet, dass beim Eindiffundieren des Donators aus den Prädepositionsbereichen (9a) die durch die Gräben (16a,b) strukturierte Oberfläche des Substrats (1) gleichzeitig mit einer Abdeckschicht (12) versehen wird.

3. Verfahren nach Anspruch 2, dadurch gekennzeichnet, dass das Substrat aus Si und die Abdeckschicht (12) aus $SiO_2$ besteht.

4. Verfahren nach Anspruch 3, dadurch gekennzeichnet, dass

(a) die Prädepositionsschicht (9) bis zu einer Tiefe (t1) von weniger als 2 μm in das Substrat (1) hineinreicht;

(b) die Gräben (16a,b) bis zu einer Tiefe (t2) von ungefähr gleich oder grösser als 10 μm ausgehoben werden; und

(c) der Donator aus den Prädepositionsbereichen (9a) zur Bildung der n-Emitterbereiche (13) bis zu einer Tiefe (t3) in das Substrat (1) eindiffundiert wird, welche grösser ist als die Tiefe (t2) der Gräben (16a,b).

5. Verfahren nach Anspruch 4, dadurch gekennzeichnet, dass die Tiefe (t2) der Gräben (16a,b) etwa 10 μm und die Tiefe (t3) der n-Emitterbereiche (13) etwa 15 μm beträgt.

6. Verfahren nach Anspruch 3, dadurch gekennzeichnet, dass zum Anbringen von Kathodenelektroden (14) und Gateelektroden (15) über den n-Emitterbereichen (13) und in den Gräben (16a) Fenster in die Abdeckschicht (12) eingebracht werden.

EP 0 360 050 A1

FIG.1A

FIG.1B

FIG.1C

FIG.1D

FIG.1E

FIG.2A

FIG.2B

FIG.2C

FIG.2D

FIG.2E

Europäisches
Patentamt

**EUROPÄISCHER RECHERCHENBERICHT**

Nummer der Anmeldung

EP 89 11 6096

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Band 11, Nr. 212 (E-522)[2659], 9. July 1987; & JP-A-62 032 646 (MITSUBISHI ELECTRIC CORP.) 12-02-1987 * Zusammenfassung; Figur 1 * | 1-3,6 | H 01 L 21/332 H 01 L 21/225 |
| A | IDEM --- | 4,5 | |
| A | US-A-4 210 472 (ITT INDUSTRIES INC.) * Figuren 1-5; Seite 2, Zeile 25 - Seite 3, Zeile 14 * --- | 1-4 | |
| A | DE-A-3 037 316 (TOSHIBA K.K.) * Figuren 1-9; Seite 9, Zeile 31 - Seite 12, Zeile 11 * ----- | 1,4,5 | |
| | | | **RECHERCHIERTE SACHGEBIETE (Int. Cl.5)** |
| | | | H 01 L |

Der vorliegende Recherchenbericht wurde für alle Patentansprüche erstellt

| Recherchenort | Abschlußdatum der Recherche | Prüfer |
|---|---|---|
| DEN HAAG | 05-12-1989 | GELEBART J.F.M. |

EPO FORM 1503 03.82 (P0403)